Europäisches Patentamt

European Patent Office

Office européen des brevets

(11) Numéro de publication : **0 390 661 B1**

(12) **FASCICULE DE BREVET EUROPEEN**

(45) Date de publication du fascicule du brevet :
**30.08.95 Bulletin 95/35**

(51) Int. Cl.$^6$ : **H01L 21/20,** H01L 21/205,
H01L 21/329, H01L 29/205,
H01S 3/19

(21) Numéro de dépôt : **90400810.9**

(22) Date de dépôt : **23.03.90**

(54) **Procédé de modulation dirigée de la composition ou du dopage de semiconducteurs, notamment pour la réalisation de composants électroniques monolithiques de type planar, utilisation et produits correspondants.**

(30) Priorité : **31.03.89 FR 8904257**

(43) Date de publication de la demande :
**03.10.90 Bulletin 90/40**

(45) Mention de la délivrance du brevet :
**30.08.95 Bulletin 95/35**

(84) Etats contractants désignés :
**DE GB IT NL**

(56) Documents cités :
**DE-A- 3 022 565**
**US-A- 4 725 112**
**GALLIUM ARSENIDE AND RELATED COMPOUNDS 1986, PROCEEDINGS OF THE 13THINTERNATIONAL SYMPOSIUM, Las Vegas, Nevada, 28 septembre - 1 octobre 1986,pages 1-8, IOP Publishing Ltd, Bristol, US; H. WATANABE et al.: "Atomic layerepitaxy"**

(56) Documents cités :
**APPLIED PHYSICS LETTERS, vol. 51, no. 19, 9 novembre 1987, pages 1518-1520,American Institute of Physics, New York, US; H. ASAI et al.: "Narrow two-dimensional electron gas channels in GaAs/AlGaAs sidewall interfaces byselective growth"**

(73) Titulaire : **THOMSON-CSF**
**173, Boulevard Haussmann**
**F-75008 Paris (FR)**

(72) Inventeur : **Karapiperis, Léonidas**
**Thomson-CSF,**
**SCPI - Cédex 67**
**F-92045 Paris la Défense (FR)**
Inventeur : **Pribat, Didier**
**Thomson-CSF,**
**SCPI - Cédex 67**
**F-92045 Paris la Défense (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

EP 0 390 661 B1

## Description

L'invention a trait au domaine de la fabrication par dépôt en phase vapeur des couches minces d'un matériau monocristallin, polycristallin ou amorphe, sur un substrat de nature identique ou différente.

L'invention couvre également la réalisation de composants électroniques monolithiques, notamment au sein de circuits intégrés (CI), au moyen d'un tel procédé de fabrication de couches minces.

Le procédé décrit selon l'invention permet en particulier de faire varier de manière contrôlée les profils de composition et/ou de dopage de telles couches dans un sens dirigé, notamment dans un sens latéral parallèle à la surface du substrat, à la différence des techniques habituelles d'épitaxie ou de dopage qui créent des profils de modulation de composition ou de dopage qui varient essentiellement dans un sens normal à la surface du substrat.

Plus précisémment, dans le domaine de la microéléctronique et des semiconducteurs III-V en particulier, un procédé fondamental dans la réalisation de dispositifs discrets ou de circuits intégrés est l'obtention par croissance épitaxiale de couches dopées à différents niveaux sur des substrats semiconducteurs. On connaît plusieurs méthodes d'épitaxie, telles que notamment l'Epitaxie en Phase Vapeur (VPE, de l'anglais Vapour Phase Epitaxy) et ses variantes, comme, notamment, la MOCVD (de l'anglais Metal Organic Chemical Vapour Deposition), ou l'épitaxie par jets moléculaires (MBE, de l'anglais Molecular Beam Epitaxy). Dans la pratique actuelle, un trait commun entre toutes ces méthodes est que le profil de composition réalisé lors d'un même dépôt est uniforme dans un plan donné parallèle à la surface du substrat, et ne peut varier que dans un sens normal à la surface du substrat. Cela est suffisant, et même indispensable, dans la plupart des cas dans la technologie planar des CI. Il y a cependant des cas où il serait avantageux de pouvoir faire varier le profil de composition de zones actives de dispositifs dans une direction parallèle au plan de la surface du substrat.

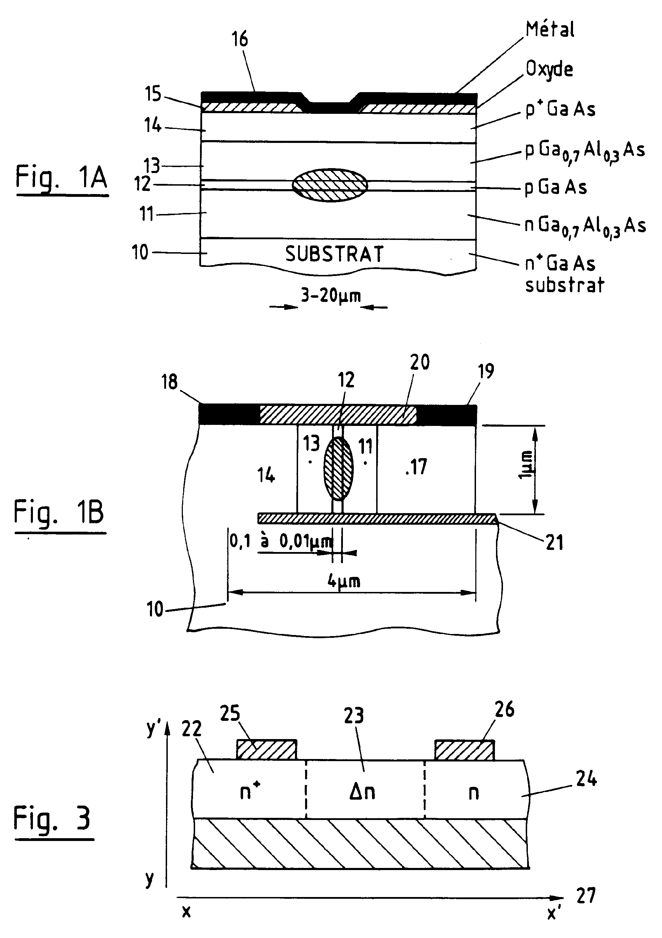

Un exemple type est la réalisation d'un laser planar, dont la composition des diverses couches varie dans un sens parallèle au plan de la surface du substrat semiconducteur. La figure 1A montre le schéma d'un laser simple en GaAlAs/GaAs/GaAlAs, obtenu de façon connue par croissance normale au plan du substrat 10. La figure 1B montre la disposition des couches d'un laser planar dont la direction de croissance est parallèle au plan du substrat 10, et dont la structure a donc subi une rotation de 90° par rapport au laser connu de la figure 1A.

Or, jusqu'à aujourd'hui, il n'existe aucune méthode qui puisse réaliser la structure de la figure 1B.

Un premier objectif de la présente invention est de fournir un procédé de fabrication de dispositifs à variation dirigée du profil de composition, et notamment d'un tel laser planar.

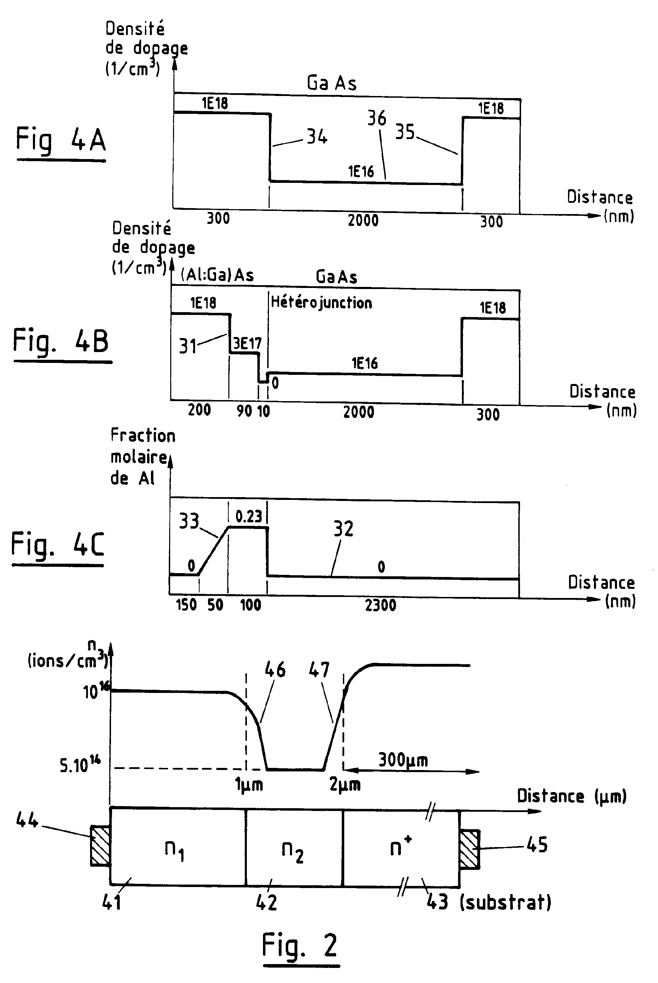

Dans le domaine de la microélectronique aujourd'hui, un autre procédé fondamental dans la réalisation de dispositifs discrets ou de circuits integrés est la définition de zones actives dans le substrat semiconducteur par dopage. On connaît plusieurs méthodes de dopage, à savoir notamment l'implantation ionique, l'épitaxie en phase vapeur, ou la diffusion thermique. Dans la pratique actuelle, un trait commun entre toutes ces méthodes est que le profil de dopage réalisé lors d'une même étape est uniforme dans un plan donné parallèle à la surface du substrat. Cela est suffisant, et même indispensable, dans la plupart des cas dans la technologie planar de CI. Il y a cependant des cas où il serait avantageux de pouvoir faire varier le profil de dopage d'une zone active dans une direction parallèle au plan de la surface du substrat, par exemple pour la réalisation d'une diode plane hyperabrupte à capacité variable et à profil de dopage latéralement gradué, comme représenté en figures 2 et 3.

Un procédé connu pour créer des profils de dopage latéralement variables est offert par les faisceaux d'ions focalisés, une approche qui permet l'implantation sans masque avec une résolution latérale de l'ordre de 0.1μm [Voir, J. Melngailis, J. Vac. Sci. Technol., B5(2), 469 (1987), sur la technologie et les applications des faisceaux focalisés]. Plusieurs documents de brevet publiés reposent sur cette idée (voir notamment les publications françaises 8518985, 8518984 et 8519494). Cette approche est séduisante, mais elle souffre d'un désavantage majeur, lié au faible courant d'émission des sources d'ions : la très lente vitesse d'écriture. De plus, elle nécessite l'emploi de machines à faisceaux d'ions focalisés qui sont encore dans un stade de developpement nettement pré-industriel. En outre, une étape de recuit thermique d'activation des dopants est nécessaire, comme dans le cas de l'implantation ionique standard.

Un second objectif de l'invention est de fournir un procédé de modulation dirigée (notamment latérale) du profil de dopage, suivant un principe assez simple, d'une haute définition latérale, et, surtout, pouvant s'effectuer avec les moyens couramment employés dans l'industrie de la microélectronique (figure 3).

Enfin, on peut envisager aussi des applications où on a besoin d'une modulation à la fois du profil de dopage et du profil de composition. De tels dispositifs ont été déjà proposés dans la littérature, comme par exemple, des oscillateurs Gunn à cathode à hétérojonction (Al:Ga)As (voir A.Al-Omar et al, Proceeding IEEE/Cornell Conference on Advanced Concepts in High Speed Semiconductor Devices and Circuits, Aug. 1987, p.365). Une telle structure est représentée aux figures 4B, 4C en regard d'une structure de diode Gunn conventionnelle à deux fronts abrupts 34,35 du profil de dopage 36, pour comparaison (fig 4A). La structure connue des figures 4B et 4C est une structure "verticale", c'est-à-dire, une structure dont les profils de dopage 31 et de composition 32 (à noter la modulation graduée 33 du profil 32 du côté de la cathode) varient dans un sens normal au plan du substrat.

Un troisième objectif essentiel de l'invention est donc de fournir un procédé permettant de réaliser cette structure comportant à la fois une modulation de la composition et du dopage, dans une direction non normale à la surface du substrat, notamment de façon latérale pour obtenir une technologie type planar et pouvoir intégrer ce dispositif dans un circuit.

Concernant l'exemple ci-dessus, il faut souligner que l'invention permet aussi bien la réalisation des profils de dopage et/ou de composition latéralement gradués que la haute définition latérale requise par ce dispositif.

Ces objectifs, ainsi que d'autres qui apparaîtront par la suite sont atteints à l'aide d'un procédé de réalisation d'une couche mince constituée d'au moins un matériau semiconducteur monocristallin avec modulation de la composition et/ou du dopage de ladite couche selon lequel on réalise ladite couche mince par épitaxie sélective forcée, initiée sur un germe monocristallin, à partir d'une phase gazeuse, entre deux couches de confinement en matériau distinct du semiconducteur, de telle façon qu'il ne peut y avoir ni nucléation, ni dépôt de matériau semiconducteur sur les surfaces desdites couches de confinement et en ce qu'on commande la variation de la composition du mélange gazeux de ladite phase gazeuse pour obtenir ladite modulation de la composition et/ou du dopage de ladite couche mince.

Selon un premier mode de réalisation, pour l'obtention d'une couche mince constituée d'au moins deux matériaux semiconducteurs monocristallins distincts, la modulation de la composition de ladite couche est obtenue par modification commandée et contrôlée dans ledit mélange gazeux, de la pression partielle et/ou de la fraction molaire des gaz utiles servant à engendrer le dépôt solide de matériaux semiconducteurs monocristallins, tout en maintenant la sélectivité du dépôt.

Selon un second mode de réalisation, pour la réalisation d'une couche mince constituée d'au moins un matériau semiconducteur monocristallin avec modulation du dopage dans ladite couche, on commande ladite modulation par variation dans ledit mélange gazeux, de la pression partielle et/ou de la fraction molaire de gaz dopants, tout en maintenant la sélectivité du dépôt.

Avantageusement, la technique d'épitaxie utilisée est une épitaxie sélective, du type appartenant au groupe comprenant notamment la CVD, la MOCVD et la méthode VPE aux chlorures, à pression atmosphérique ou réduite.

Selon une caractéristique essentielle de l'invention, ladite épitaxie forcée est réalisée dans une cavité latérale de confinement réalisée à partir d'une structure stratifiée diélectrique/couche temporaire/diélectrique déposée sur un substrat monocristallin, selon la méthode décrite dans les documents de brevets antérieurs 88 04 437 et 88 04 438, comme détaillé plus loin.

Avantageusement, mais non limitativement, la couche temporaire peut être réalisée en silicium amorphe ou polycristallin, en $SiO_2$, ou dans la variété polycristalline de matériau servant de germe monocristallin, et à partir duquel est initiée l'épitaxie forcée. L'invention concerne également l'utilisation du procédé, notamment pour la réalisation d'une diode laser ou photo détecteur en semiconducteur à gap direct (comme par exemple an AsGa, InP, quaternaires et autres), d'une diode Gunn planar à cathode à hétérojonction, et d'une diode Schottky planar à capacité variable et profil hyperabrupt, ces exemples n'étant pas limitatifs. Elle concerne également les couches minces et composants électroniques réalisés suivant le procédé.

D'autres caractéristiques et avantages de l'invention apparaîtront à la lecture suivante de la description de modes de réalisation préférentiels de mise en oeuvre du procédé de l'invention, notamment pour la réalisation de composants spécifiques à modulation latérale du dopage ou de la composition, et des dessins annexés dans lesquels :

- la figure 1A représente un laser simple en GaAlAs/GaAs/GaAlAs, obtenu de façon connue par croissance normale au plan du substrat, et la figure 1B représente un laser planar de même composition, obtenu suivant le procédé de l'invention ;
- la figure 2 représente la structure et le profil de dopage d'une diode plane hyperabrupte à capacité variable, et à profil de dopage latéralement gradué, obtenue selon l'état de l'art ;
- la figure 3 représente la structure d'une diode Schottky à capacité variable, à profil hyperabrupt, réalisée en technologie planar selon le procédé de l'invention ;
- la figure 4A représente le profil de dopage d'une diode Gunn connue à cathode à hétérojonction, et les figures 4B et 4C représentent respectivement le profil de dopage et le profil de composition (fraction molaire d'amuminium) d'une diode gunn à profils variables, réalisable de façon planar suivant le procédé de l'invention ;
- les figures 5A à 5I schématisent les étapes successives d'un mode de mise en oeuvre du procédé de l'invention pour la réalisation du laser planar de la figure 1B ;
- les figures 6A à 6C représentent les étapes caractéristiques d'un mode de mise en oeuvre du procédé de l'invention pour la réalisation d'une diode Schottky planar du type de la figure 2 ;

- les figures 7A à 7F schématisent les étapes successives d'une variante de mise en oeuvre des étapes 1 à 11 pour la réalisation de la diode laser GaAs planar de la figure 1A, ou de la diode Schottky de la figure 2 ;
- les figures 8A à 8D résument les étapes principales de mise en oeuvre du procédé de réalisation pour les cavités de confinement d'une opération de croissance épitaxiale dirigée, telle que décrit dans le document de brevet 8804437 ;
- les figures 9A à 9D résument les étapes principales d'un second mode de mise en oeuvre du procédé décrit ,dans le document de brevet français 8804437 pour la réalisation de cavités de croissance épitaxiale dirigée ;
- la figure 10 schématise le principe de "piège à défauts de croissance hétéroépitaxiale" ,tel que décrit dans le document de brevet français 8804438.

Le procédé de l'invention a pour objectif de permettre une modulation dirigée, notamment en direction latérale parallèlement au plan du substrat, de la composition et/ou du dopage, lors de la formation à partir d'une phase vapeur des couches minces d'un matériau polycristallin ou amorphe, mais préférentiellement monocristallin.

La mise en oeuvre du procédé de l'invention repose de façon essentielle sur les procédés de réalisation d'une alternance de couches de matériaux semi-conducteurs monocristallins et de couches de matériaux isolants, tels que décrits dans les documents de brevets français 8804437 et 8804438.

Le procédé décrit dans le document de brevet 8804437 concerne la réalisation par croissance à partir d'une phase vapeur d'une couche mince monocristalline d'un matériau semiconducteur, caractérisé en ce que la croissance est initiée sur un germe d'un matériau monocristallin du même type que le matériau semiconducteur de la couche mince à obtenir et est confinée entre deux couches en matériau distinct du matériau semiconducteur de telle façon qu'il ne peut y avoir ni nucléation ni dépôt de matériau semiconducteur sur les surfaces exposées de ce ou de ces matériaux distincts, l'intervalle entre les deux couches du ou des matériaux distincts définissant l'épaisseur de la couche mince monocristalline à obtenir.

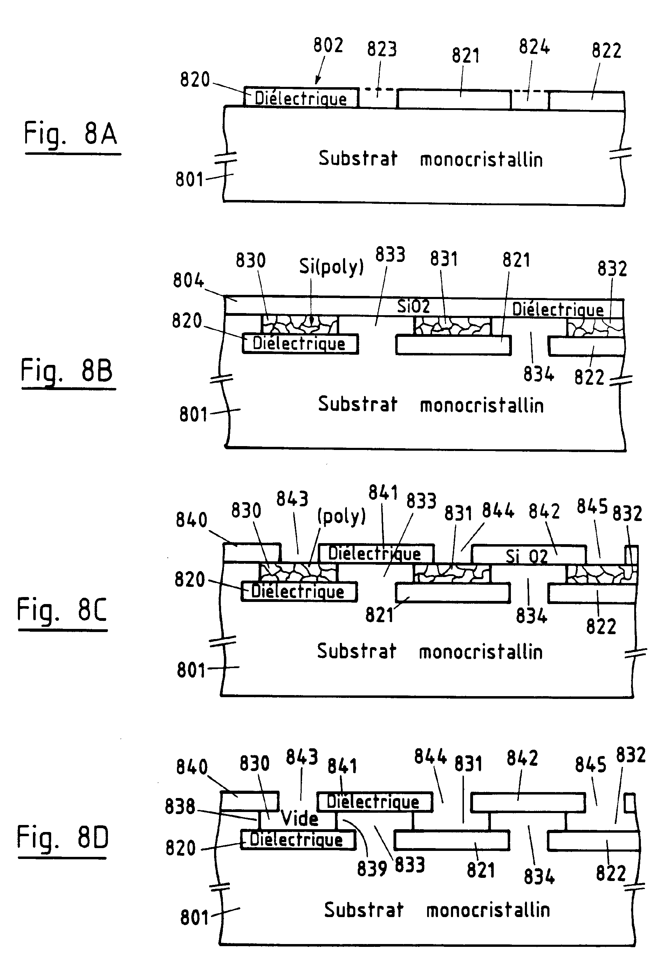

Comme illustré aux figures 8A à 8D, un premier mode de réalisation illustratif et non limitatif de ce procédé de réalisation d'une couche de matériau semi-conducteur monocristallin sur une première couche d'un matériau isolant 802 réalisée sur un substrat 801 semi-conducteur monocristallin, comporte les étapes suivantes :
- une première étape de réalisation sur le substrat 801 semiconducteur monocristallin de ladite première couche de matériau isolant 802 présentant une sélectivité d'attaque chimique par rapport au semiconducteur sous-jacent et ne permettant ni nucléation, ni dépôt à partir des espèces de ladite phase vapeur sur sa surface exposée à la phase vapeur, de composition adaptée ;
- une deuxième étape de gravure de premières ouvertures 823, 824 dans la première couche 802 de matériau isolant ;
- une troisième étape de réalisation dans les premières ouvertures 823, 824, et sur les parties de la couche d'isolant 820, 821, 822, restant après l'étape de gravure précédente, d'une couche d'un matériau semiconducteur 830 à 834, cette couche étant monocristalline dans les ouvertures 823, 824 et polycristalline sur l'isolant 820, 821, 822 ;
- une quatrième étape de réalisation d'une deuxième couche 804 d'un matériau isolant sur la couche de matérieu semiconducteur 830 à 834 ;
- une cinquième étape de gravure dans la deuxième couche 804 de matériau isolant, d'au moins une deuxième ouverture 843, 844 aboutissant sur une partie polycristalline 830, 831, 832, de la couche de matériau semiconducteur 830 à 834 ;
- une sixième étape d'attaque chimique du matériau semiconducteur polycristallin 830, 831, 832, de façon à supprimer tout le matériau semiconducteur polycristallin et éventuellement de façon a légèrement attaquer le matériau monocristallin.

Dans le procédé décrit, les cavités 830, 831, 832 dégagées servent à la croissance dirigée, en phase vapeur, d'un matériau semi-conducteur monocristallin. Comme on le verra ci-après, selon le procédé de la présente invention, ces mêmes cavités 830, 831, 832 vont servir pour effectuer une croissance épitaxiale dirigée d'un matériau cristallin avec modulation contrôlée de la composition et/ou du dopage du matériau.

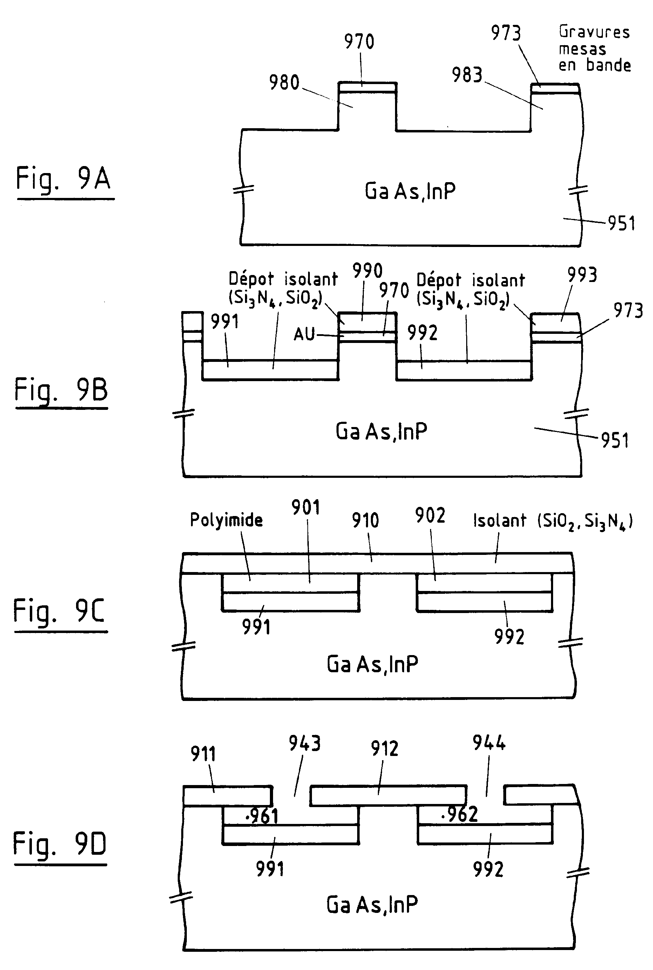

Les figures 9a à 9D schématisent une seconde variante de réalisation des cavités, également décrite dans le document de brevet français 8804437.

Selon cette variante, on effectue les étapes suivantes :
- une première étape de réalisation de mésas 980, 983 en bandes d'une hauteur déterminée dans un substrat semiconducteur monocristallin 951, par exemple par attaque chimique du substrat 951 après masquage 970, 973 (Fig 9A).
- une deuxième étape de dépôt, sur le substrat entre les mésas 980 d'un matériau diélectrique 991, 992 dont l'épaisseur est inférieure à la hauteur des mésas (Fig 9B), les couches diélectriques 990, 993 et les couches de masquage 970, 973 déposées sur les mésas étant ensuite éliminées par "lift off" ;

- une troisième étape de dépôt sur le matériau diélectrique 991, 992, d'un matériau intercalaire 901, 902, de type organique présentant une sélectivité d'attaque chimique par rapport au matériau diélectrique 990, 991, 992 et à la couche 910 de matériau supérieur qui sera déposée ultérieurement dont l'épaisseur est telle que son addition à l'épaisseur du matériau diélectrique 991, 992 permet d'égaler la hauteur des mésas (Fig 9C) ;
- une quatrième étape de dépôt sur l'ensemble des mésas 980, 983, et du matériau intercalaire 901, 902, d'une couche 910 d'un matériau encapsulant présentant une sélectivité d'attaque chimique par rapport à la couche de matériau organique et ne permettant ni nucléation, ni dépôt à partir des espèces de ladite phase vapeur sur les surfaces exposées dudit matériau encapsulant ; (Fig 9C)
- une cinquième étape de réalisation d'ouvertures 943, 944 dans la couche 910 de matériau encapsulant dans des zones aboutissant sur du matériau intercalaire 901, 902 ;
- une sixième étape d'élimination, par les ouvertures 943, 944, du matériau intercalaire 901, 902 ; (Fig 9D).

Les cavités 961, 962 ainsi dégagées serviront pour la croissance épitaxiale dirigée du procédé de la présente invention, avec modulation de la composition et/ou du dopage de semi-conducteurs.

D'autres modes de réalisation des cavités 830, 831,832 ; 961, 962 sont envisageables par l'homme de métier et elles sont décrites dans les documents 88 04437 et 88 04438.

Le document de brevet français 8804438 décrit pour sa part un procédé permettant de bloquer la propagation des défauts apparaissant au cours de la croissance d'un structure hétéroépitaxiale d'un matériau monocristallin, notamment des défauts inhérents au mode de croissance, des défauts engendrés par la mise sous contrainte du dépôt lors du refroidissement, et d'autres causes de défauts.

Le procédé selon l'invention consiste à interposer sur le trajet de croissance du cristal en couche mince à obtenir, un étranglement qui va bloquer la croissance des défauts.

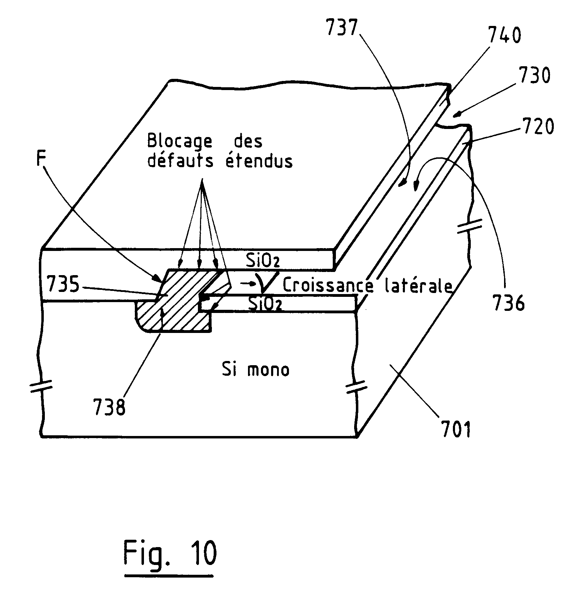

La figure 10 illustre de façon simplifiée le procédé de base de l'invention. Selon ce procédé on réalise un structure comportant principalement un espace 730 délimité par les faces 736 et 737 de deux couches 720 et 740. Les deux couches 720 et 740 sont en matériau sur lequel, compte tenu des conditions de dépôt utilisées, on n'observe pas de dépôt du matériau semiconducteur à faire croître. Dans le fond de l'espace 730 est située une portion ou germe 738 d'un matériau semiconducteur (par exemple le substrat). Plus précisément, selon l'exemple de réalisation présenté les couches 720 et 740 sont réalisées sur un substrat 701. Le germe 738 est alors une partie du substrat 701 située au dessous du plan de la surface 736 de la couche 720.

Dans ces conditions, une épitaxie sélective d'un matériau semiconducteur réalisée dans l'espace 730 donne lieu à une croissance monocristalline du matériau semiconducteur sur le germe 738. Cette croissance progresse perpendiculairement au plan du germe 738 (verticalement) jusqu'à remplir la cavité 735, puis progresse latéralement (horizontalement) dans l'espace 730.

Si le matériau semiconducteur épitaxié est différent de celui du substrat 701, on voit que la croissance épitaxiale s'effectue d'abord verticalement dans la cavité 735 et ensuite latéralement entre les bandes de diélectrique 720 et 740. Ainsi les défauts générés lors de l'étape de croissance verticale (hétéroépitaxie) sont bloqués par les couches diélectriques 720 et 740, lors de l'étape de croissance latérale. D'autre part, il n'y a pas génération de nouveaux défauts lors de cette même étape de croissance latérale car le procédé est devenu homoépitaxial lors de la croissance latérale ; les défaut une fois bloqués disparaissent donc définitivement de la couche mince. La cavité 735 représente en fait un piège à défauts.

On notera toutefois que la croissance du cristal dans tous les cas ne peut s'effectuer de façon latérale que si l'on peut se placer dans des conditions telles que l'on n'ait pas de dépôt sur les surfaces 736 et 737 des couches de confinement 720 et 740. Il doit en être de même en ce qui concerne les surfaces des couches 802 et 804, ainsi que 991, 992 et 910. Ceci est réalisé dans des conditions de dépôt sélectif, c'est-à-dire notamment par le choix des matériaux en présence, et l'ajustement de la température de réaction et des pressions partielles respectives des constituants de la phase gazeuse.

On va maintenant présenter des modes de mise en oeuvre illustratifs de l'invention, en relation respectivement avec une modulation latérale de la composition d'une couche mince en matériau monocristallin dans un premier temps, et la modulation latérale du dopage d'une couche mince en matériau monocristallin dans un second temps.

## Modulation latérale de la composition

Ce mode de réalisation du procédé de l'invention peut s'effectuer avec pratiquement tous les semiconducteurs que l'on utilise aujourd'hui dans l'industrie de la microélectronique (silicium, composés III-V, composés II-VI, etc...). Les semiconducteurs type pour la zone active du dispositif laser que l'on considèrera ici à titre illustratif et non limitatif, sont le GaAs et les composés ternaires du type GaAlAs. De façon générale en ce qui concerne les composés laser, l'invention est applicable à des semi-conducteurs III-V (type GaAS, InP ainsi leurs différents dérivés ternaires ou quaternaires) à gap direct. On entend par semi-conducteur à gap direct, tout semi-conducteur dans lequel les transitions électroniques entre bande de valence et bande de conduction s'effectuent sans émission ou absorption d'un phonon.

En ce qui concerne le substrat de départ, on peut considérer deux cas de figure :

a. Substrat Si, comme cas typique (mais pas limitatif) d'hétéroépitaxie, et,

b. Substrat GaAs.

Dans le premier cas, il faut prendre toutes les précautions nécessaires pour bloquer la propagation latérale des défauts engendrés par le désaccord de maille entre GaAs et Si, par le differentiel dans leurs constantes de dilatation thermique et par la nature différente (polaire et non-polaire) des deux semiconducteurs. Ceci est schématisé sur la figure 10. Selon le type de défauts présents, une deuxième étape d'épitaxie latérale pourrait être nécessaire (en sens croisé par rapport à la première) pour l'élimination totale des défauts liés à l'hétéroépitaxie, comme décrit en détail dans le document de brevet français 88 04438 précité.

Dans le deuxième cas, on n'est pas confronté aux difficultés fondamentales de l'hétéroepitaxie. On peut, donc, largement suivre le schéma de l'homoépitaxie exposé dans le document de brevet franvais 88 04437 et brièvement commenté sur les figures 8 et 9.

Pour être concret, mais non limitatif, on prendra comme application type à réaliser la structure de laser latéral portée sur la Fig 1B. Afin de ne pas compliquer les choses inutilement, on considérera le cas le plus simple, c'est-à-dire le cas d'un substrat GaAs. Bien entendu, le procédé peut s'appliquer aussi bien dans le cas d'un substrat Si sous condition que la procédure nécessaire précitée pour l'élimination des défauts dans la zone active soit suivie.

Comme représenté en figure 1B, l'objectif est de réaliser une diode laser planar sur substrat GaAs 10 présentant successivement les couches suivantes (en direction latérale) :

- $p^+$GaAS (zone 14) ;
- p $Ga_{0,7}Al_{0,3}$As (zone 13);
- p GaAs (zone 12 active) ;
- n $Ga_{0,7}Al_{0,3}$As (zone 11) ;
- $n^+$GaAs (zone 17).

La succession de zones s'étend par exemple sur une couche mince d'épaisseur 1$\mu$m, et de largeur 4$\mu$m environ. La largeur de la zone active 12 est par exemple de 0,1 à 0,01$\mu$m.

Plusieurs avantages importants découlent de cette structure plan, par rapport à la même structure "verticale" de la Fig 1A. Ainsi, la structure est complétement plane, et les plages de contact 18, 19 de commande du dispositif se trouvent sur la surface de la plaquette, à l'encontre des structures classiques lesquelles disposent d'un contact sur la face avant de la plaquette, et d'un deuxième sur la face arrière. La possibilité de disposer les deux électrodes 18, 19 sur la face avant facilite énormément l'intégration, et permet la commande complétement indépendante de chaque laser sur une même plaquette. De plus, des électrodes de contrôle supplémentaire (non représentées) peuvent être rajoutées, par exemple sur la zone active du dispositif, avec une couche diélectrique interposée.

Dans l'industrie du GaAs, on utilise couramment plusieurs methodes d'épitaxie en phase vapeur (VPE) à pression atmosphérique ou réduite, selon l'application voulue. Pour l'application type ici considérée, la technique la plus adaptée serait la MOCVD (Metaloganic Chemical Vapour Epitaxy) à pression réduite.

Cette technique est celle qui est couramment utilisée dans la fabrication de lasers à hétérojonction, tout en permettant, et celà est essentiel pour la mise en oeuvre de l'invention, la réalisation d'épitaxie sélective (voir par exemple K.KAMON et collaborateurs dans l'article page 73 du "Journal of Crystal Growth", 73, 1985). De façon connue de l'homme de métier, l'épitaxie sélective consiste en l'épitaxie, sur un substrat comportant des zones monocristallines d'un type donné A et des zones de nature différente, d'un matériau monocristallin sur les zones monocristallines de type A tout en supprimant le dépôt sur les zones restantes. Afin d'obtenir facilement une épitaxie sélective, on peut aussi utiliser une méthode type VPE tel que le procédé à base de $AsCl_3$ et Ga en incorporant une source additionnelle de trimethyl aluminium par exemple (voir par exemple M.ERMAN et coll., SPIE vol.651, Integrated optical Circuit Engineering III (1986) 75).

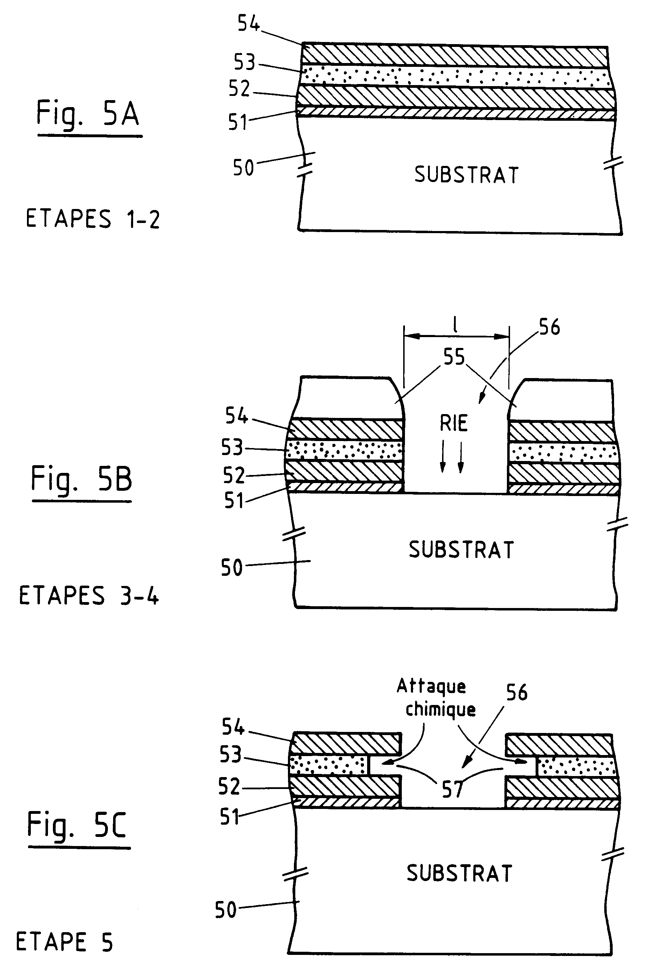

Schématiquement, le procédé de réalisation du dispositif ici considéré va maintenant être détaillé, en relation avec les figures 5A à 5I :

Etape 1 : Sur un substrat monocristallin GaAs 50 on dépose par pulvérisation cathodique une couche 51 de $Si_3N_4$ d'une épaisseur comprise entre quelques centaines et quelques milliers Angströms (entre $10^{-8}$ et $10^{-7}$m). Cette couche d'encapsulation permettra, si nécessaire, une étape de recuit à une température de 800-850°C dans une atmosphère d'oxygène pour la densification de la silice déposée.

Etape 2 : En trois étapes, et par les moyens connus de dépôt CVD basse température, on réalise trois couches successives de $SiO_2$,52, de Silicium amorphe 53, et de nouveau de $SiO_2$,54 dont les épaisseurs sont toutes comprises, entre quelques dixièmes de micromètre et quelques micromètres. On pourra si nécessaire recuire la silice après chaque dépôt dans une atmosphère d'oxygène à 800 - 850°c.

Etape 3 : Sur le stratifié ainsi défini on étale une couche de résine photolithographique 55 d'une épaisseur suffisante pour la gravure par ions réactifs (RIE, de l'anglais : Reactive Ion Etching) qui suit dans l'étape 4. Par photolithographie on réalise dans cette couche des ouvertures en forme de bandes parallèles d'une largeur comprise entre quelques dixièmes de micromètre et quelques micromètres, et d'un espacement périodique compris entre dix et quelques centaines de micromètres. L'orientation des bandes est fonction de l'orientation du substrat et est choisie de façon à optimiser la vitesse et le facettage de l'épitaxie latérale sélective et forcée à suivre.

Etape 4 : A l'aide du masque de résine 55, on grave par RIE dans le stratifié de quatre couches sousjacentes 51, 52, 53, 54 des bandes 56 dont la largeur est définie par le masque. Pour éviter tout endommagement du substrat par l'attaque RIE on peut enlever les dernières dizaines de nanomètres de silice 52 et de $Si_3N_4$ 51 restants par des moyens de chimie aqueuse. Le masque de résine 55 s'enlève soit chimiquement, soit par attaque en plasma oxygène.

Etape 5 : Par les moyens d'une solution chimique qui attaque sélectivement le Si sans affecter la silice, on agrandit la largeur de l'ouverture 56 dans la couche de Si amorphe 53 de quelques micromètres, de façon à définir des ouvertures latérales de remplissage 57.

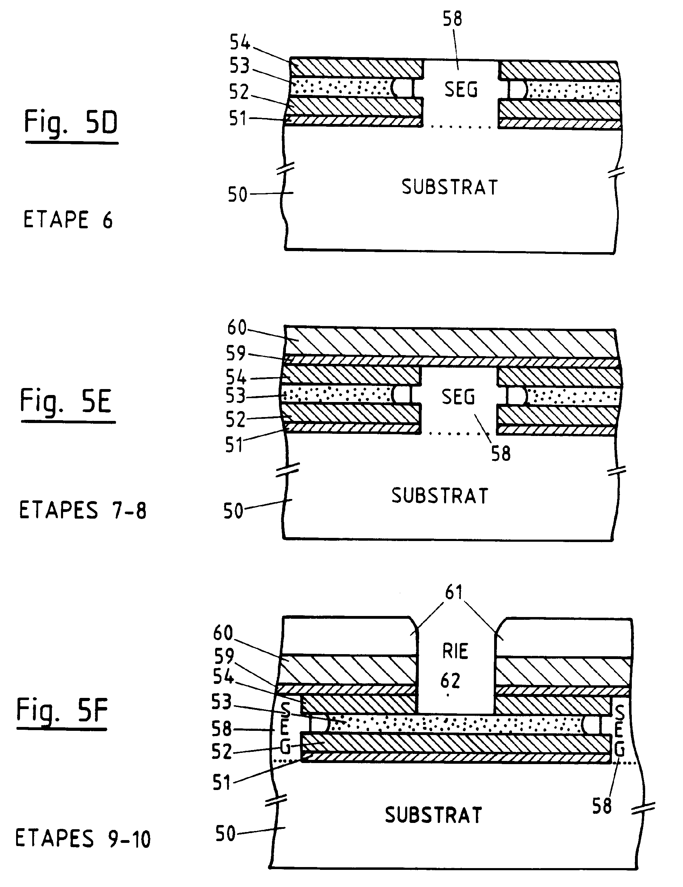

Etape 6 : En se plaçant sous des conditions d'épitaxie GaAs sélective (soit en MOCVD à pression réduite, soit en VPE), on remplit les ouvertures 56, 57 (Fig 5D) précédemment définies, de GaAs monocristallin 58 de façon à planariser la structure.

Etape 7 : Sur toute la surface de la plaquette, on dépose par pulvérisation cathodique une couche 59 de $Si_3N_4$ d'une épaisseur comprise entre quelques centaines et quelques milliers d'Angstroms. (Fig 5E).

Etape 8 : On dépose par une méthode CVD basse température, et sur toute la surface de la plaquette, une couche de silice 60 d'une épaisseur comprise entre quelques dixièmes de micromètres et quelques micromètres (Fig 5E).

Etape 9 : Par photolithographie, on définit dans une couche de résine 61 d'une épaisseur suffisante pour l'attaque par RIE de la couche de silice 60 sousjacente un réseau d'ouvertures 62, en forme de bandes, d'une périodicité identique à celle du réseau 56, défini dans l'Etape 3, mais décalé par rapport à celui-ci de façon à se situer à mi-distance entre les bandes 56 ou 58 du premier réseau, et d'une largeur comprise entre quelques dixièmes de micromètres et quelques micromètres. (Fig 5F).

Etape 10 : A l'aide du masque de résine 61, on grave par RIE dans les couches de silice 60 et de $Si_3N_4$ 59 sousjacentes des bandes 62 dont la largeur est définie par le masque 61 (Fig 5F).

Etape 11 : A l'aide d'une solution chimique qui attaque sélectivement le Si sans affecter la silice, on enlève à travers les ouvertures 62 dans la couche de silice la couche 53 de Si amorphe ou polycristallin sousjacente, mettant ainsi à nu les régions de GaAs monocristallin 58 qui serviront de germe pour l'étape suivante. (Fig 5G).

Etape 12 : En se plaçant dans des conditions d'épitaxie selective, on réalise, à partir du germe 58, une croissance latérale "forcée" de GaAs dopé $p^+$ 63 (en utilisant du Diméthyl Zinc, par exemple, pour le dopant). L'extension de cette croissance peut être de quelques micromètres à quelques dizaines de micromètres.

Etape 13 : Toujours dans des conditions d'épitaxie sélective, mais en ajoutant un gaz porteur d'Al (du Trimethyl Aluminium, par exemple) dans la concentration appropriée, on ajoute une tranche de $Ga_{0,7}Al_{0,3}As$ dopé p 64 (en utilisant du Diméthyl Zinc, par exemple, pour le dopant) de largeur $10^{-2}$ à quelques $10^{-1}$ micromètres.

Etapes 14 et 15 : En ajustant les proportions des gaz porteurs et des dopants comme dans l'étape 13, on ajoute par épitaxie forcée encore deux tranches, une de GaAs type p 65, et une de $Ga_{0,7}Al_{0,3}As$ type n 66, chacune de largeur $10^{-2}$ à quelques $10^{-1}$ micromètres.

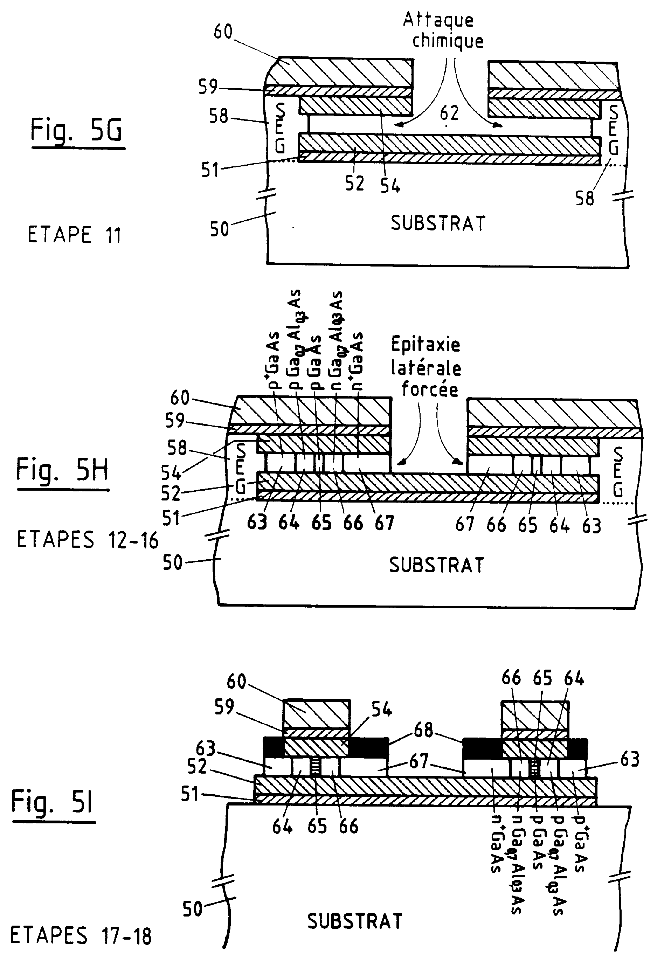

Etape 16 : On ajoute par épitaxie forcée une tranche finale de GaAs dopé $n^+$ 67 de largeur de quelques micromètres à quelques dizaines de micromètres (voir fig 5H pour les étapes 12, 13, 14, et 16).

Etape 17 : Par photolithographie et gravure chimique ou RIE, on enlève une partie de la couche de diélectrique 54 sur les zones $p^+$ GaAs et $n^+$ GaAs pour prendre les contacts métalliques 68 de commande du laser (voir fig 5I).

Etape 18 : Si nécessaire, la région active 65 du laser peut être isolée de la zone de germination par gravure chimique ou RIE. Enfin, afin de définir la cavité laser dans le sens longitudinal, on utilisera une attaque chimique anisotropique, de façon à former des parois semi réfléchissantes faisant un angle de 90° avec le plan du substrat (voir par exemple, l'article de Y.TARNI et collaborateurs, Journal of the Electrochemical Society, vol. 118, n°1, p 118, 1971).

Le procédé ici décrit concerne la réalisation d'un ensemble de dispositifs identiques périodiquement disposés sur un substrat semiconducteur. Ces dispositifs, après découpage, peuvent être utilisés en tant que composants discrets. Bien évidemment, rien n'empêche la réalisation de tels dispositif individuellement, à des endroits bien déterminés sur la surface d'une puce de façon à faire partie d'un circuit intégré.

Modulation latérale du dopage

Ce mode de réalisation du procédé de l'invention peut s'effectuer avec pratiquement tous les semiconducteurs que l'on utilise aujourd'hui dans l'industrie de la microélectronique.

Comme dans le cas de la modulation latérale de la composition de semiconducteurs, elle repose de façon essentielle sur le procédé d'épitaxie latérale forcée (document de brevet français 88 04437 précité). Dans ce procédé, une place importante est occupée par l'épitaxie sélective de semiconducteurs qui peut s'effectuer, en fonction des matériaux impliqués, par une des méthodes d'épitaxie classique, telles que la CVD pour le silicium (Voir par exemple, L.Jastrzebski et al, J.Vac Scie. Technol., 130, 1571 (1983), et L. Karapiperis et al, Proceedings, MRS Symposium, Boston, Dec. 1987) ; la MOCVD pour les composés III-V (Voir, par exemple, R.P Gale et al, Appl. Phys. Lett., 41, 545 (1982), et K.Yamaguchi et al, Jpn. J. Appl. Phys., 24 (12) 1666 (1985) ; la methode VPE aux chlorures (selon le process $AsCl_3 - GaAs-H_2$), également pour les composés III-V, (Voir, par exemple, C.O.Bozler et al, J..Vac. Sci. Technol. 20 (3), 720 (1982), et N.Vodjani et al, J.Crys. Growth, 71, 141 (1985)).

De plus, le procédé proposé ici pour la modulation du dopage latéral peut bénéficier, également, de tous les avantages du procédé de base d'épitaxie latérale, notamment la suppression dans les couches minces des défauts engendrés lors de l'hétéroépitaxie de deux semiconducteurs différents (document de brevet français 88 04438 précité). Il en est ainsi, notamment, si l'on souhaite réaliser une couche active en GaAs sur substrat Si.

Dans le cas où les zones actives dans la couche réalisée par épitaxie latérale forcée nécessitent un dopage uniforme, cela peut, bien évidemment, se faire par implantation standard ou diffusion thermique des dopants. Ces deux méthodes impliquent forcément au moins un niveau de masquage, s'il s'agit d'un seul type de dopant, et, dans le cas de l'implantation ionique, une étape supplémentaire de recuit thermique est nécessaire pour la guérison des défauts induits, et l'activation des dopants. Le procédé de l'invention ici décrit permet potentiellement, même dans le cas du dopage uniforme, une simplification du processus, grâce au dopage in situ pendant la croissance épitaxiale de la couche active, éliminant ainsi au moins une étape de masquage. Une simplification supplémentaire, par rapport à l'implantation ionique, est l'élimination de l'étape de recuit thermique d'activation cela n'est pas nécessaire dans le cas du dopage effectué durant l'épitaxie. Le procédé de l'invention présente un intérêt particulier pour le GaAs qui, de par sa fragilité, ne supporte par toujours très bien l'implantation ionique (création de défauts difficilement guérissables) ni le recuit d'activation, lequel de plus nécessite une encapsulation préalable de la surface ($Si_3N_4$ ou $SiO_2$).

Le semiconducteur type que l'on considérera ici sera le GaAs pour la zone active du dispositif et pour le substrat, sans, pourtant, que cela puisse être considéré comme limitatif pour l'invention. A titre d'exemple, on va décrire ici la réalisation d'une diode de type Schottky à capacité variable, à profil hyperabrupt, ou à pente linéaire ou quelconque, et structure plane, du type schematisé en Fig 3.

Les diodes à capacité variable ont de nombreuses applications telles que l'accord électronique des oscillateurs, la détection, le mélange ou la génération d'harmoniques des signaux. Leur caractéristique principale est que leur capacité varie en fonction inverse de la tension de polarisation V qui leur est appliquée, selon l'expression :

$$C = A (V + \phi - Vn)^{-k}$$

dans laquelle,
- A est une constante
- $\phi$ est la hauteur de la barrière de Schottky
- Vn est la position du niveau de Fermi comptée en valeur absolue à partir du bas de la bande de conduction.
- k=1/(m+2), où m est le paramètre définissant la variation de dopage n en fonction de la distance d, par rapport à la surface selon : $n = f(d^m)$

La capacité d'une diode à capacité variable est donc liée au paramètre m, pour une tension de polarisation donnée.

Les diodes connues de ce type sont réalisées par épitaxie classique et sont, par conséquent, de structure "verticale". Une diode à pente linéaire est réalisée, selon l'art connu, de la façon suivante : sur un substrat 43 fortement dopé n+ à $10^{18}$ ions/cm3 on dépose par épitaxie deux couches 42 et 41 de matériau semiconducteur (Fig 2). La couche 41 est dopée n à $10^{16}$ ions/cm3. La couche 42 est une région de transition, symbolisée par $\Delta$ n. Dans le cas le plus simple elle est dopée uniformément n à un niveau de l'ordre $5 \times 10^{14}$, de façon à réaliser deux transitions "hyperabruptes" 46, 47 à l'interface avec les couches 41, et le substrat 43. Deux électrodes 45 sont prévues pour la commande du dispositif. Il est bien évident que ce procédé de réalisation, en affectant uniformément à chaque étape toute la surface de la plaquette, est bien adapté pour la réalisation de dispositifs discrets, mais nullement pour la réalisation des dispositifs de ce type au sein d'un circuit intégré.

La solution apportée par l'invention est représentée schématiquement par la Figure 3 : Le dispositif, de structure "latérale" et plane, peut être réalisé par le procédé d'épitaxie latérale forcée sélectivement dans les zones désirées d'un circuit intégré. On distingue ainsi les 3 zones $n^+$(22), n (23), et n (24) se succédant dans la direction xx' parallélement à la surface du substrat 27. Les électrodes de commande 25, 26 sont disposées à la surface de la couche mince 22, 23, 24 ce qui facilite énormément l'intégration du dispositif dans un circuit complexe. Bien évidemment, rien n'empêche l'utilisation du procédé ici décrit pour la réalisation de dispositifs à profil de dopage variable et de structure plane sous la forme de composants discrets. Il faut remarquer que le procédé d'épitaxie latérale forcée permet la réalisation de transitions latérales abruptes de dopage sur une largeur voisine de la centaine d'Angströms($10^{-8}$m). Le niveau du dopage peut-être modulé de manière controlée dans le sens latéral (direction xx'), mais il reste uniforme dans le plan du front de croissance (yy') (Fig 3).

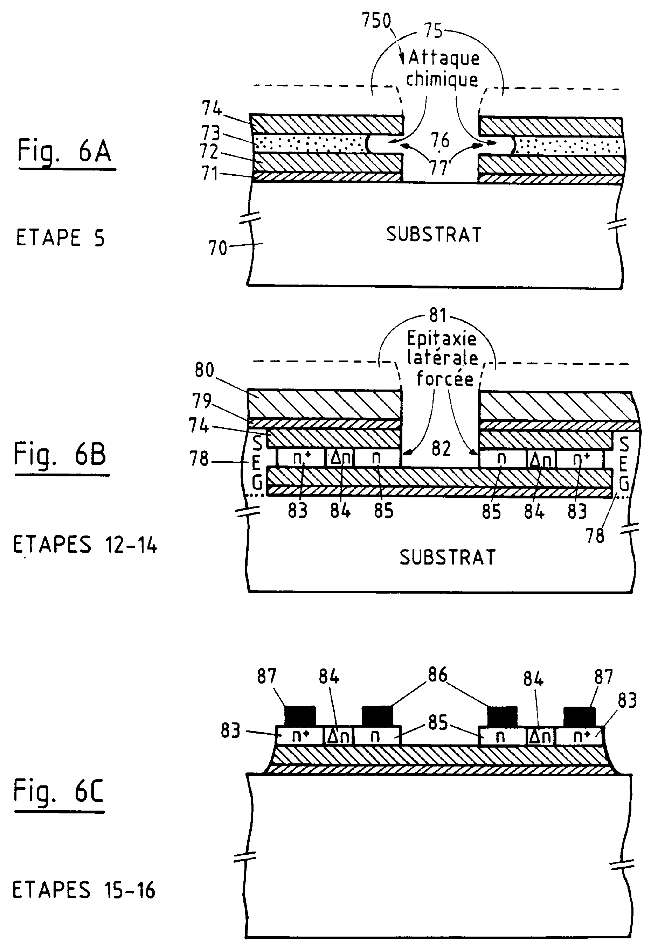

Le procédé décrit ci-dessous en relation avec les Fig 6A à 6C concerne la réalisation d'un ensemble de dispositifs identiques périodiquement disposés en couples sur la surface du substrat semiconducteur. On notera que les étapes 1 à 4 et 6 à 11 ne font pas l'objet d'une figure spécifique, du fait de la similitude de déroulement de cette phase du procédé avec ce qui est décrit précédemment en relation avec les Fig 5A à 5I.

Etape 1 : Sur un substrat monocristallin GaAs 70, on dépose par pulvérisation cathodique une couche de $Si_3N_4$ 71, d'une épaisseur comprise entre quelques centaines et quelques milliers d'Angströms ($10^{-8}$ à $10^{-7}$m). Cette couche permettra, si nécessaire, une étape de recuit à une température de 800-850°C dans une atmosphère oxygène pour la densification de la silice déposée (Etape 2Bis).

Etape 2 : En trois étapes, et par les moyens connus de dépôt CVD basse température, on réalise trois couches successives de $SiO_2$ 72, de Silicium amorphe 73, et de nouveau de $SiO_2$ 74, dont les épaisseurs sont toutes comprises, entre quelques dixièmes de micromètre et quelques micromètres.

Etape 2 bis : Recuit à 800-850°C dans une atmosphère oxygène pour densifier la silice, si nécessaire.

Etape 3 : Sur le stratifié ainsi défini, on étale une couche de résine photolithographique 75 d'une épaisseur suffisante pour la gravure par ions réactifs (RIE, de l'anglais Reactive Ion Etching) qui suit dans l'étape 4. Par photolithographie on réalise dans cette couche des ouvertures 750 en forme de bandes parallèles d'une largeur comprise entre quelques dixièmes de micromètre et quelques micromètres, et d'un espacement périodique compris entre dix et quelques centaines de micromètres. L'orientation des bandes est fonction de l'orientation du substrat et est choisie de façon à optimiser la vitesse et le facettage de l'épitaxie latérale forcée à suivre.

Etape 4 : A l'aide du masque de résine on grave par RIE dans le stratifié de 4 couches sousjacentes 71, 72, 73, 74, des bandes 76 dont la largeur est définie par le masque. Pour éviter tout endommagement du substrat par l'attaque RIE on peut enlever les dernières dizaines de nanomètres de silice 72 et de $Si_3N_4$ 71 restants par des moyens de chimie aqueuse. Le masque de résine 75 s'enlève soit chimiquement, soit par attaque en plasma oxygène.

Etape 5 : Par les moyens d'une solution chimique qui attaque sélectivement le Si sans affecter la silice, on agrandit la largeur de l'ouverture 76 dans la couche de Si amorphe de quelques micromètres, de façon à définir des ouvertures latérales de remplissage 77 (Fig 6A).

Etape 6 : En se plaçant sous des conditions d'épitaxie GaAs sélective on remplit complétement les ouvertures 76, 77 précédemment définies de GaAs monocristallin 78 de façon à planariser la structure.

Etape 7 : Sur toute la surface de la plaquette on dépose par pulvérisation cathodique une couche de $Si_3N_4$ 79 d'une épaisseur comprise entre quelques centaines et quelques milliers d'Angströms ($10^{-8}$ à $10^{-7}$m).

Etape 8 : On dépose par une méthode CVD basse température, et sur toute la surface de la plaquette, une couche de silice 80 d'une épaisseur comprise entre quelques dixièmes de micromètre et quelques micromètres.

Etape 9 : Par photolithographie, on définit dans une couche de résine 81 d'une épaisseur suffisante pour l'attaque par RIE de la couche de silice sousjacente 80 un réseau d'ouvertures 810 en forme de bandes d'une périodicité identique à celle du réseau défini dans l'étape 3, mais décalé par rapport à celui-ci de façon à se situer à mi-distance entre les bandes du premier réseau, et d'une largeur comprise entre quelques dixièmes de micromètre et quelques micromètres.

Etape 10 : A l'aide du masque de résine 81 on grave par RIE dans les couches de silice 80 et de $Si_3N_4$ 79 sousjacentes des bandes 82 dont la largeur est définie par le masque 81.

Etape 11 : A l'aide d'une solution chimique qui attaque sélectivement le Si sans affecter la silice on enlève à travers les ouvertures dans la couche de silice la couche de Si amorphe ou polycristallin sousjacente 73, mettant ainsi à nu les régions 78 de GaAs monocristallin qui serviront de germe pour l'étape suivante. (non représenté)

Etape 12 : En se plaçant sous des conditions d'épitaxie sélective, et à partir des germes 78 mis à nu dans l'étape précédente, on réalise une épitaxie latérale forcée de GaAs de type n+ (83) sur une largeur comprise entre quelques micromètres et quelques dizaines de micromètres dans le vide laissé par l'enlèvement de la couche de Si amorphe ou polycristallin 73. Le dopage de type n peut-être obtenu par ajout de $SiH_4$ dans la phase vapeur.

Etape 13 : En réduisant brutalement la concentration du dopant de type n (c'est-à-dire la pression partielle de $SiH_4$ dans la phase gazeuse) pour réaliser une transition abrupte, on poursuit l'épitaxie latérale forcée en modulant la concentration du dopant (donc la pression partielle de $SiH_4$) de façon à créer le profil désiré dans la zone n (84). La largeur de cette zone 84 peut varier entre quelques dixièmes de micromètre et plusieurs micromètres.

Etape 14 : On augmente brutalement le niveau de dopage n pour obtenir, toujours par épitaxie latérale forcée, une zone 85 de type n dopée à $10^{16}$ions/cm³ (voir fig 6B).

Etape 15 : Par une méthode de gravure standard on peut isoler complétement chaque dispositif du substrat.

Etape 16 : Par dépôt de métaux tels que Ti, Au etc... on réalise, selon l'art connu, deux contacts Schottky 86, 87 par dispositif, ce qui complète la fabrication du dispositif.

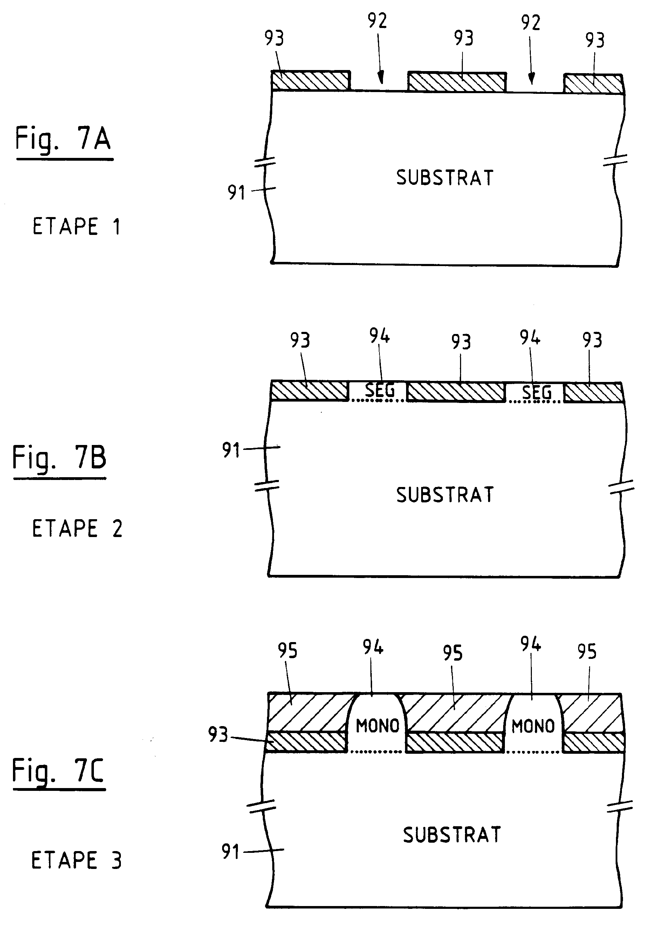

Les figures 7A à 7F illustrent une variante de remplacement des étapes 1 à 11, pour les deux modes de réalisation du procédé de l'invention décrits plus haut en relation avec les Fig. 5A et 5I et 6A à 6C. Cette variante correspond à une mise en oeuvre du mode de réalisation des cavités latérales de confinement 830, 831, 832, décrit plus haut en relation avec les Fig 8A à 8D.

Dans cette variante, on peut schématiser le processus de réalisation de chaque cavité en disant qu'il consiste à provoquer la croissance sélective d'au moins un plot (94) cristallin de germination à la surface d'un substrat cristallin (91), à déposer un stratifié diélectrique (96)/couche temporaire (95)/diélectrique (96) sur ladite surface munie du ou des plots (94) de façon que la couche diélectrique supérieure (96) du stratifié repose approximativement au niveau de la partie supérieure dudit ou desdits plots (94), et à éliminer ladite couche temporaire (95) du stratifié à partir d'au moins une ouverture (98) pratiquée dans le stratifié jusqu'à atteindre ledit plot cristallin (94).

Etape 1 : On part d'un substrat monocristallin de GaAs semi-isolant 91 comportant des zones nues 92, en forme de bandes d'une largeur comprise entre un micromètre et quelques micromètres et d'une longueur comprise entre quelques dizaines de micromètres et quelques centimètres, séparées de zones 93 recouvertes d'une couche diélectrique telle que la silice ($SiO_2$) ou le nitrure de silicium ($Si_3N_4$), d'une largeur de 10 à quelques 100 micromètres. L'épaisseur de cette couche 93 est de $10^{-2}$ à quelques micromètres. L'orientation des bandes est fonction de l'orientation du substrat et est choisie de façon à optimiser la vitesse et le facettage de l'épitaxie latérale forcée à suivre (Fig 7A)

Etape 2 : Sous des conditions de sélectivité, on réalise une croissance épitaxiale (SEG - Selective Epitaxial Growth) de GaAs semi-isolant 94 dans les zones nues 92 (zones de germination) de façon à planariser la structure. (Fig 7B)

Etape 3 : Ensuite, en changeant la température de dépôt et la concentration en gaz porteurs de Ga et As, on réalise en même temps une épitaxie dans les zones monocristallines 94 et un dépôt polycristallin 95 de même épaisseur sur l'isolant 93. Les étapes 2 et 3 peuvent s'effectuer séquentiellement, sans sortir l'échantillon du réacteur. (Fig 7C)

Comme variante, on pourrait réaliser cette étape dans un reacteur MBE (Molecular Beam Epitaxy) (épitaxie à jet moléculaire).

Etape 4 : Par une méthode CVD basse température, on dépose une couche de diélectrique 96 ($SiO_2$ ou $Si_3N_4$) d'une épaisseur $10^{-2}$ μm à quelques micromètres. (Fig 7D).

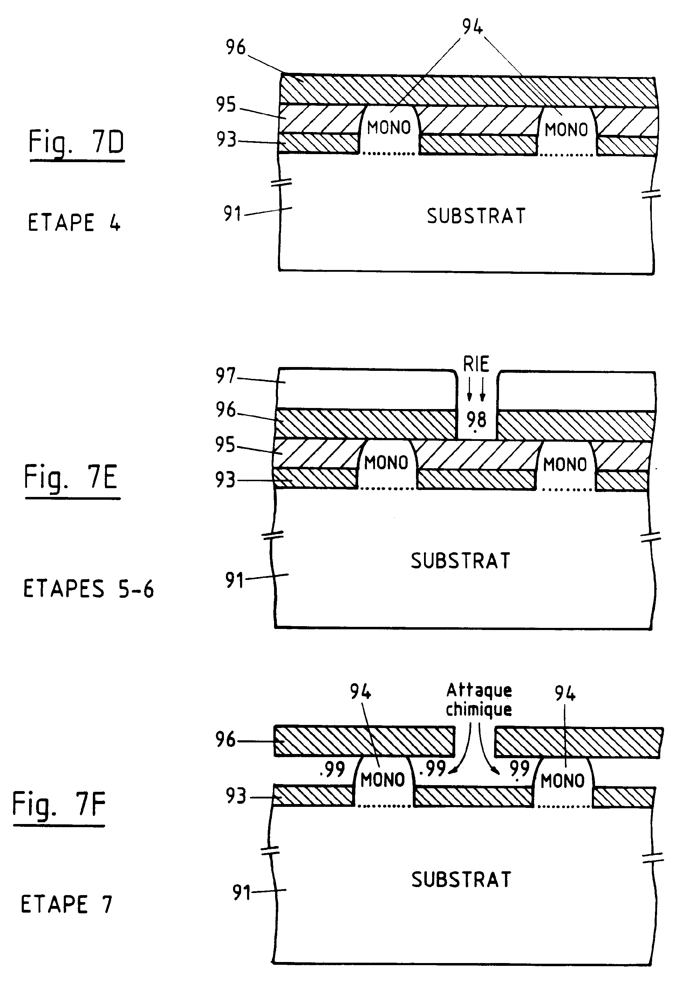

Etape 5 : Par une méthode photolithographique, on réalise un réseau d'ouvertures dans une couche de résine 97, d'une épaisseur de 0,5 μm à quelques micromètres, en forme de bandes parallèles aux bandes de germination et d'une même périodicité, mais décalées par rapport à celles-ci de façon à se situer à mi-distance entre les zones de germination. La largeur des ouvertures dans la résine est de à 0,5 μm à quelques micromètres. (Fig 7E)

Etape 6 : En se servant de la résine de masque 97, on grave par une méthode RIE (Reactive Ion Etching) les ouvertures 98 dans la couche diélectrique à travers les ouvertures de la résine, jusqu'à la couche de GaAs polycristallin sousjacente 95 (Fig 7E).

Etape 7 : En utilisant une solution qui attaque sélectivement le GaAs polycristallin 95 sans attaquer les diélectriques 93, 96 on attaque le GaAs polycristallin 95, jusqu'au dégagement du germe monocristallin, 94 (Fig 7F). On est donc ramenés au cas des fig 5-G et 6-A précédemment décrites.

Les cavités 99 dégagées servent ensuite de cavités de confinement pour la phase de croissance monocristalline à modulation de dopage et / ou de composition suivant l'invention, à partir des germes 94. D'autres variantes sont encore possibles, à partir des cas décrits dans les documents de brevets français 88 04437 et 88 04438 précités.

D'une manière générale, l'invention concerne également tout composant électronique, discret ou intégré, à émission laser, constitué de la juxtaposition sensiblement horizontale sur un substrat d'une jonction active entre deux couches de confinement.

Elle concerne aussi tout composant électronique de type GUNN, discret ou intégré, constitué de la juxtaposition sensiblement horizontale sur un substrat d'une zone semiconductrice de transition à dopage modulé latéralement entre deux zones de dopage fixe.

Dans ces composants, selon l'invention, les électrodes de commande sont avantageusement disposées de façon coplanaire à la surface de couches de contact appropriées.

## Revendications

1. Procédé de réalisation d'une couche mince constituée d'au moins un matériau semiconducteur monocristallin avec modulation de la composition et/ou du dopage de ladite couche selon lequel on réalise ladite couche mince (63, 64, 65, 66, 67, 83, 84, 85) par épitaxie sélective forcée, initiée sur un germe monocristallin (58, 94), à partir d'une phase gazeuse, entre deux couches de confinement (52, 54 ; 72, 74) en matériau distinct du semiconducteur, de telle façon qu'il ne peut y avoir ni nucléation, ni dépôt de matériau semiconducteur sur les surfaces desdites couches de confinement (52,54 ; 72, 74) caractérisé en ce qu'on commande la variation de la composition du mélange gazeux de ladite phase gazeuse pour obtenir ladite modulation de la composition et/ou du dopage de ladite couche mince (63, 64, 65, 66, 67 ; 83, 84, 85).

2. Procédé selon la revendication 1 pour la réalisation d'une couche mince (63, 64, 65, 66, 67) constituée d'au moins deux matériaux semiconducteurs monocristallins distincts, caractérisé en ce que la modulation de la composition de ladite couche est obtenue par modification commandée et contrôlée dans ledit mélange gazeux, de la pression partielle et/ou de la fraction molaire des gaz utiles servant à engendrer le dépôt solide de matériaux semiconducteurs monocristallins.

3. Procédé selon la revendication 1, pour la réalisation d'une couche mince (83, 84, 85) constituée d'au moins un matériau semiconducteur monocristallin avec modulation du dopage dans ladite couche, caractérisé en ce qu'on commande ladite modulation par variation dans ledit mélange gazeux, de la pression partielle et/ou de la fraction molaire des gaz dopants.

4. Procédé selon la revendication 1 caractérisé en ce que la technique d'épitaxie utilisée est une épitaxie sélective, du type appartenant au groupe comprenant notamment la CVD, la MOCVD et la méthode VPE aux chlorures, à pression atmosphérique ou réduite.

5. Procédé selon la revendication 1 caractérisé en ce que ladite épitaxie forcée est réalisée dans une cavité latérale de confinement réalisée à partir d'un stratifié diélectrique (52 ; 72)/couche temporaire (53 ; 73)/diélectrique (54 ; 74) déposé sur un substrat monocristallin (50 ; 70).

6. Procédé selon la revendication 1 caractérisé en ce que la dite épitaxie forcée est initiée sur un germe monocristallin (58,77,94) disposé à une extrémité de la cavité latérale de confinement.

7. Procédé selon la revendication 5 caractérisé en ce que le processus de réalisation de ladite cavité latérale consiste à assurer dans un premier temps, la croissance à partir du substrat (50 ; 70) d'un germe monocristallin (58; 78), dans au moins une première ouverture (56, 57 ; 76, 77) pratiquée dans le stratifié, et à réaliser dans un second temps, une élimination de la couche temporaire (53) du stratifié à partir d'au moins une seconde ouverture (62, 82) pratiquée dans le stratifié jusqu'à atteindre ledit germe cristallin (58, 78) remplissant ladite première ouverture (56, 57 ; 76, 77).

8. Procédé selon la revendication 5 caractérisé en ce que le processus de réalisation de ladite cavité consiste à provoquer la croissance sélective d'au moins un plot (94) cristallin de germination à la surface d'un substrat cristallin (91), à déposer un stratifié diélectrique (96)/couche temporaire (95)/diélectrique (96) sur ladite surface munie du ou des plots (94) de façon que la couche diélectrique supérieure (96) du stratifié repose approximativement au niveau de la partie supérieure dudit ou desdits plots (94), et à éliminer ladite couche temporaire (95) du stratifié à partir d'au moins une ouverture (98) pratiquée dans le stratifié jusqu'à atteindre ledit plot cristallin (94).

9. Procédé selon l'une quelconque des revendications 5 à 7 caractérisé en ce que ladite couche temporaire (53, 73 ; 95) du stratifié est constituée en silicium amorphe ou polycristallin , et en ce que ladite étape d'élimination de la couche temporaire (53, 73 ; 95) consiste en une attaque chimique.

10. Procédé selon l'une quelconque des revendications 6 à 9 caractérisé en ce que ladite couche temporaire est constituée de la variété polycristalline (95) du matériau servant de germe monocristallin (94).

11. Procédé selon l'une quelconque des revendications 5 à 7 caractérisé en ce que lesdites couches diélectriques (52, 54 ; 72, 74 ; 93, 96) du stratifié sont constituées en $SiO_2$ et/ou $Si_3N_4$.

12. Procédé selon l'une quelconque des revendications 5 à 8 caractérisé en ce que la dite couche temporaire (53,73 ; 95) est en SiO$_2$.

13. Procédé selon l'une quelconque des revendications 7 ou 8, caractérisé en ce que lesdites ouvertures pratiquées dans le stratifié sont réalisées par gravure par ions réactifs RIE.

14. Procédé selon l'une quelconque des revendications 7 ou 8, caractérisé en ce qu'on réalise une pluralité de germes monocristallins (58, 78), plots monocristallins (94) respectivement, sur un même substrat (50, 70), deux germes (58, 78), plots monocristallins (94) adjacents étant espacés d'une valeur comprise entre 10 μm et quelques centaines de micromètres environ.

15. Procédé selon l'une quelconque des revendications 1 à 14 caractérisé en ce qu'on met en oeuvre ladite croissance épitaxiale forcée dans une cavité de confinement comprenant une zone de piège à défauts par modification de la direction de croissance épitaxiale.

16. Procédé selon l'une quelconque des revendications 2 ou 3 caractérisé en ce qu'on dispose les contacts métalliques de commande (18, 19 ; 25, 26 ; 68 ; 86, 87) des composants obtenus après croissance sur la face supérieure de la couche mince réalisée par épitaxie forcée.

17. Utilisation du procédé selon la revendication 1 ou 2, pour la réalisation d'une diode laser en semi-conducteur à gap direct en structure planaire, caractérisée en ce qu'on utilise une technique d'épitaxie sélective dirigée en phase vapeur pour la croissance latérale des zones (63, 64, 65, 66, 67) de la diode laser, préférentiellement la technique MOCVD à pression réduite.

18. Utilisation du procédé selon la revendication 1 ou 3, pour la réalisation d'une diode Schottky planar à capacité variable et profil hyperabrupt, caractérisée en ce qu'on utilise une technique d'épitaxie sélective dirigée en phase vapeur pour la croissance latérale des zones (83, 84, 85) de la diode Schottky.

19. Utilisation du procédé selon au moins une des revendications 1 à 3 pour la réalisation d'une diode Gunn à cathode à hétérojontion caractérisée en ce qu'on utilise une technique d'épitaxie sélective dirigée en phase vapeur pour la croissance latérale des zones représentatives des profils de dopage (31) et de composition (32) de la diode Gunn.

20. Utilisation du procédé selon la revendication 1 pour la réalisation d'un composant électronique discret ou intégré à émission laser caractérisé en ce qu'il est constitué de la juxtaposition sensiblement horizontale sur un substrat d'une jonction active (65, 66) entre deux couches de confinement (64, 66).

21. Utilisation du procédé selon la revendication 1 pour la réalisation d'un composant électronique discret ou intégré caractérisé en ce qu'il est constitué de la juxtaposition sensiblement horizontale sur un substrat d'une zone semiconductrice de transition (84) à dopage modulé latéralement entre deux zones de dopage fixe (83, 85).

22. Composant électronique selon l'une quelconques des revendications 20 ou 21 caractérisé en ce que les électrodes de commande (68 ; 86, 87) dudit composant sont disposées de façon coplanaire à la surface de couches de contact (63, 67 ; 83, 85).

**Patentansprüche**

1. Verfahren zur Bildung einer aus wenigstens einem einkristallinen Halbleitermaterial bestehenden Dünnschicht mit Modulation der Zusammensetzung und/oder der Dotierung der Schicht, bei welchem die Dünnschicht (63, 64, 65, 66, 67, 83, 84, 85) durch an einem einkristallinen Keim (58, 94) eingeleitete erzwungene selektive Epitaxie, ausgehend von einer Gasphase, zwischen zwei Einschlußschichten (52, 54; 72, 74) aus einem von dem Halbleiter verschiedenen Material gebildet wird, derart, daß weder eine Nukleation noch ein Absetzen von Halbleitermaterial auf den Oberflächen der Einschlußschichten (52, 54; 72, 74) stattfinden kann, dadurch gekennzeichnet, daß zur Erzielung der Modulation der Zusammensetzung und/oder der Dotierung der Dünnschicht (63, 64, 65, 66, 67; 83, 84, 85) die Veränderung der Zusammensetzung der Gasmischung der Gasphase gesteuert wird.

2. Verfahren nach Anspruch 1 zur Bildung einer Dünnschicht (63, 64, 65, 66, 67), die aus wenigstens zwei verschieden einkristallinen Halbleitermaterialien besteht, dadurch gekennzeichnet, daß die Modulation der Zusammensetzung der Schicht durch gesteuerte und kontrollierte Änderung des Partialdrucks und/oder des Molenbruchs der zur Erzeugung des Feststoffniederschlags von einkristallinen Halbleitermaterialien dienenden nutzbaren Gase in der Gasmischung erhalten wird.

3. Verfahren nach Anspruch 1 für die Bildung einer aus wenigstens einem einkristallinen Halbleitermaterial bestehenden Dünnschicht (83, 84, 85) mit Modulation der Dotierung in der Schicht, dadurch gekennzeichnet, daß die Modulation durch Veränderung des Partialdrucks und/oder des Molenbruchs der Dotierungsgase in der Gasmischung gesteuert wird.

4. Verfahren nach Anspruch 1, dadurch gekennzeichnet, daß die angewendete Epitaxietechnik eine selektive Epitaxie von der Art ist, die zu der Gruppe gehört, die insbesondere die CVD, die MOCVD und das VPE-Verfahren mit Chloriden bei Atmosphärendruck oder verringertem Druck enthält.

5. Verfahren nach Anspruch 1, dadurch gekennzeichnet, daß die erzwungene Epitaxie in einem lateralen Einschlußhohlraum durchgeführt wird, der ausgehend von einer auf ein einkristallines Substrat (50; 70) aufgebrachten Schichtanordnung aus Dielektrikum (52; 72)/temporärer Schicht (53; 73) /Dielektrikum (54; 74) gebildet worden ist.

6. Verfahren nach Anspruch 1, dadurch gekennzeichnet, daß die erzwungene Epitaxie an einem einkristallinen Keim (58, 77, 94) eingeleitet wird, der an einem Ende des lateralen Einschlußhohlraums angeordnet ist.

7. Verfahren nach Anspruch 5, dadurch gekennzeichnet, daß der Vorgang der Bildung des lateralen Hohlraums darin besteht, in einer ersten Zeit vom Substrat (50; 70) aus einen einkristallinen Keim (58; 78) in wenigstens einer in der Schichtanordnung angebrachten ersten Öffnung (56, 57; 76, 77) wachsen zu lassen und in einer zweiten Zeit die temporäre Schicht (53) der Schichtanordnung von wenigstens einer in der Schichtanordnung angebrachten zweiten Öffnung (62, 82) aus zu entfernen, bis der die erste Öffnung (56, 57; 76, 77) ausfüllende kristalline Keim (58, 78) erreicht ist.

8. Verfahren nach Anspruch 5 dadurch gekennzeichnet, daß der Vorgang der Bildung des Hohlraums darin besteht, wenigstens einen kristallinen Keimpflock (94) an der Oberfläche eines kristallinen Substrats (91) selektiv wachsen zu lassen, eine Schichtanordnung aus Dielektrikum (96)/temporärer Schicht (95)/Dielektrikum (96) auf die mit dem Pflock bzw. den Pflöcken (94) versehene Oberfläche derart aufzubringen, daß die obere dielektrische Schicht (96) der Schichtanordnung annähernd auf der Höhe des oberen Teils des Pflocks bzw. der Pflöcke aufliegt, und die temporäre Schicht (95) der Schichtanordnung von wenigstens einer in der Schichtanordnung angebrachten Öffnung (98) aus zu entfernen, bis der kristalline Pflock (94) erreicht ist.

9. Verfahren nach einem der Ansprüche 5 bis 7, dadurch gekennzeichnet, daß die temporäre Schicht (53, 73; 95) der Schichtanordnung aus amorphem oder polykristallinem Silicium gebildet wird, und daß der Schritt der Beseitigung der temporären Schicht (53, 73; 95) in einem chemischen Ätzen besteht.

10. Verfahren nach einem der Ansprüche 6 bis 9, dadurch gekennzeichnet, daß die temporäre Schicht aus der polykristallinen Variante (95) des für den einkristallinen Keim (94) dienenden Materials gebildet wird.

11. Verfahren nach einem der Ansprüche 5 bis 7, dadurch gekennzeichnet, daß die dielektrischen Schichten (52, 54; 72, 74; 93, 96) der Schichtanordnung aus $SiO_2$ und/oder $Si_3N_4$ gebildet sind.

12. Verfahren nach einem der Ansprüche 5 bis 8, dadurch gekennzeichnet, daß die temporäre Schicht (53, 73; 95) aus $SiO_2$ besteht.

13. Verfahren nach einem der Ansprüche 7 oder 8, dadurch gekennzeichnet, daß die in der Schichtanordnung angebrachten Öffnungen durch reaktives Ionenätzen RIE gebildet werden.

14. Verfahren nach einem der Ansprüche 7 oder 8, dadurch gekennzeichnet, daß mehrere einkristalline Keime (58, 78) bzw. einkristalline Pflöcke (94) auf demselben Substrat (50, 70) gebildet werden, wobei zwei benachbarte einkristalline Keime (58, 78) bzw. Pflöcke (94) einen Abstand voneinander haben, dessen Wert zwischen etwa 10 μm und einigen 100 Mikrometern liegt.

15. Verfahren nach einem der Ansprüche 1 bis 14, dadurch gekennzeichnet, daß das erzwungene epitaxiale Wachstum in einem Einschlußhohlraum erfolgt der eine durch Änderung der Richtung des epitaxialen Wachstums als Defektfalle wirkende Zone aufweist.

16. Verfahren nach einem der Ansprüche 2 oder 3, dadurch gekennzeichnet, daß die metallischen Steuerkontakte (18, 19; 25, 26; 68; 86, 87) der nach dem Wachstum erhaltenen Bauteile auf der oberen Fläche der durch erzwungene Epitaxie gebildeten Dünnschicht angeordnet werden.

17. Anwendung des Verfahrens nach Anspruch 1 oder 2 für die Herstellung einer Laserdiode aus Halbleiter mit direktem Bandabstand in planarer Struktur, dadurch gekennzeichnet, daß für das laterale Wachstum der Zonen (63, 64, 65, 66, 67) der Laserdiode eine Technik gerichteter selektiver Epitaxie aus der Dampfphase, vorzugsweise die MOCVD-Technik bei verringertem Druck angewendet wird.

18. Anwendung des Verfahrens nach Anspruch 1 oder 3 für die Herstellung einer planaren Schottky-Diode mit veränderlicher Kapazität und hyperabruptem Profil, dadurch gekennzeichnet, daß für das laterale Wachstum der Zonen (83, 84, 85) der Schottky-Diode eine Technik gerichteter selektiver Epitaxie aus der Dampfphase angewendet wird.

19. Anwendung des Verfahrens nach wenigstens einem der Ansprüche 1 bis 3 für die Herstellung einer Gunn-Diode mit Heteroübergangs-Kathode, dadurch gekennzeichnet, daß für das laterale Wachstum der für die Dotierungsprofile (31) und die Zusammensetzung (32) repräsentativen Zonen der Gunn-Dioden eine Technik gerichteter selektiver Epitaxie aus der Dampfphase angewendet wird.

20. Anwendung des Verfahrens nach Anspruch 1 für die Herstellung eines diskreten oder integrierten elektronischen Laser-Bauteils, dadurch gekennzeichnet, daß es in einem im wesentlichen horizontalen Aneinanderfügen eines aktiven Übergangs (65, 66) zwischen zwei Einschlußschichten (64, 66) auf einem Substrat besteht.

21. Anwendung des Verfahrens nach Anspruch 1 für die Herstellung eines diskreten oder integrierten elektronischen Bauteils, dadurch gekennzeichnet, daß es in einem im wesentlichen horizontalen Aneinanderfügen einer Übergangs-Halbleiterzone (84) mit lateral modulierter Dotierung zwischen zwei Zonen (83, 85) mit fester Dotierung besteht.

22. Elektronisches Bauteil nach einem der Ansprüche 20 oder 21, dadurch gekennzeichnet, daß die Steuerelektroden (68; 86, 87) des Bauteils koplanar an der Oberfläche von Kontaktschichten (63, 67; 83, 85) angeordnet sind.

**Claims**

1. Process for producing a thin layer consisting of at least one monocrystalline semiconductor material with modulation of the composition and/or of the doping of the said layer, according to which process the said thin layer (63, 64, 65, 66, 67, 83, 84, 85) is produced by forced selective epitaxy, initiated on a monocrystalline seed (58, 94), from a gas phase, between two confinement layers (52, 54; 72, 74) made of material distinct from the semiconductor, in such a way that there is no possibility for nucleation or deposition of semiconductor material on the surfaces of the said confinement layers (52, 54; 72, 74), characterized in that the variation in the composition of the gas mixture of the said gas phase is controlled in order to obtain the said modulation of the composition and/or of the doping of the said thin layer (63, 64, 65, 66, 67; 83, 84, 85).

2. Process according to Claim 1 for the production of a thin layer (63, 64, 65, 66, 67) consisting of at least two distinct monocrystalline semiconductor materials, characterized in that the modulation of the composition of the said layer is obtained by controlled and monitored modification, in the said gas mixture, of the partial pressure and/or of the molar fraction of the working gases serving to generate the solid deposition of monocrystalline semiconductor materials.

3. Process according to Claim 1, for the production of a thin layer (83, 84, 85) consisting of at least one monocrystalline semiconductor material with modulation of the doping in the said layer, characterized in that the said modulation is controlled by varying, in the said gas mixture, the partial pressure and/or the molar fraction of the dopant gases.

4. Process according to Claim 1, characterized in that the epitaxy technique used is a selective epitaxy of the type belonging to the group which includes, especially, CVD, MOCVD and the chloride VPE method, at atmospheric or reduced pressure.

5. Process according to Claim 1, characterized in that the said forced epitaxy is carried out in a lateral confinement cavity produced from a dielectric (52; 72)/temporary layer (53; 73)/dielectric (54; 74) layered structure deposited on a monocrystalline substrate (50; 70).

6. Process according to Claim 1, characterized in that the said forced epitaxy is initiated on a monocrystalline seed (58, 77, 94) arranged at one end of the lateral confinement cavity.

7. Process according to Claim 5, characterized in that the procedure for producing the said lateral cavity consists in firstly growing, from the substrate (50; 70), a monocrystalline seed (58; 78), in at least a first opening (56, 57; 76, 77) made in the layered structure, and secondly in removing the temporary layer (53) of the layered structure via at least one second opening (62, 82) made in the layered structure until the said crystalline seed (58, 78) filling the said first opening (56, 57; 76, 77) is reached.

8. Process according to Claim 5, characterized in that the procedure for producing the said cavity consists in causing the selective growth of at least one crystalline seeding pad (94) at the surface of a crystalline substrate (91), in depositing a dielectric (96)/temporary layer (95)/dielectric (96) layered structure on the said surface provided with the pad or pads (94) so that the upper dielectric layer (96) of the layered structure lies approximately level with the upper part of the said pad or the said pads (94), and in removing the said temporary layer (95) of the layered structure via at least one opening (98) made in the layered structure until the said crystalline pad (94) is reached.

9. Process according to any one of Claims 5 to 7, characterized in that the said temporary layer (53, 73; 95) of the layered structure is made of amorphous or polycrystalline silicon and in that the said step of removing the temporary layer (53, 73; 95) consists of a chemical etch.

10. Process according to any one of Claims 6 to 9, characterized in that the said temporary layer consists of the polycrystalline variety (95) of the material serving as monocrystalline seed (94).

11. Process according to any one of Claims 5 to 7, characterized in that the said dielectric layers (52, 54; 72, 74; 93, 96) of the layered structure are made of $SiO_2$ and/or $Si_3N_4$.

12. Process according to any one of Claims 5 to 8, characterized in that the said temporary layer (53, 73; 95) is made of $SiO_2$.

13. Process according to either one of Claims 7 and 8, characterized in that the said openings made in the layered structure are produced by reactive ion etching RIE.

14. Process according to either one of Claims 7 and 8, characterized in that a plurality of monocrystalline seeds (58, 78) or monocrystalline pads (94) respectively are produced on the same substrate (50, 70), two adjacent monocrystalline seeds (58, 78) or pads (94) being spaced apart by a value lying between 10 μm and a few hundreds of micrometres approximately.

15. Process according to any one of Claims 1 to 14, characterized in that the said forced epitaxial growth is performed in a confinement cavity which includes a zone for trapping defects by modification of the direction of epitaxial growth.

16. Process according to either one of Claims 2 and 3, characterized in that the metallic contacts (18, 19; 25, 26; 68; 86, 87) for driving the components obtained after growth are arranged on the upper face of the thin layer produced by forced epitaxy.

17. Use of the process according to Claim 1 or 2, for the production of a planar-structure laser diode made of direct-gap semiconductor, characterized in that a directed selective vapour-phase epitaxy technique is used for the lateral growth of the zones (63, 64, 65, 66, 67) of the laser diode, preferably the reduced-pressure MOCVD technique.

18. Use of the process according to Claim 1 or 3, for the production of a planar Schottky varicap diode having a hyperabrupt profile, characterized in that a directed selective vapour-phase epitaxy technique is used for the lateral growth of the zones (83, 84, 85) of the Schottky diode.

19. Use of the process according to at least one of Claims 1 to 3 for the production of a heterojunction-cathode Gunn diode, characterized in that a directed selective vapour-phase epitaxy technique is used for the lateral growth of the zones representing the doping (31) and compositional (32) profiles of the Gunn diode.

20. Use of the process according to Claim 1 for the production of a discrete or integrated laser-emitting electronic component characterized in that it consists of the substantially horizontal juxtaposition, on a substrate, of an active junction (65, 66) between two confinement layers (64, 66).

21. Use of the process according to Claim 1 for the production of a discrete or integrated electronic component characterized in that it consists of the substantially horizontal juxtaposition, on a substrate, of a semiconducting transition zone (84) having laterally modulated doping between two fixed-doping zones (83, 85).

22. Electronic component according to either one of Claims 20 and 21, characterized in that the drive electrodes (68; 86, 87) of the said component are arranged so as to be coplanar with the surface of contact layers (63, 67; 83, 85).

Fig. 1A

16
15
14
13
12
11
10

Métal

Oxyde

$p^+$ Ga As

$p$ Ga$_{0,7}$ Al$_{0,3}$ As

$p$ Ga As

$n$ Ga$_{0,7}$ Al$_{0,3}$ As

$n^+$ Ga As substrat

SUBSTRAT

3–20μm

Fig. 1B

18
12
20
19
13
11
14
.17
1μm
21
0,1 à 0,01μm
4μm
10

Fig. 3

y'
22
25
23
26
24
$n^+$
Δn
$n$
y
27
x
x'

Densité
de dopage
(1/cm³)

## Fig 4A

GaAs

1E18          1E18

36  35

34

1E16

Distance
(nm)

300          2000          300

Densité
de dopage
(1/cm³)

## Fig. 4B

(Al:Ga)As          GaAs

1E18          Hétérojunction          1E18

31          3E17

0          1E16

Distance
(nm)

200  90 10          2000          300

Fraction
molaire
de Al

## Fig. 4C

33          0.23

32

0          0

Distance
(nm)

150  50  100          2300

n₃
(ions/cm³)

46  47

10¹⁶

5.10¹⁴          300µm

1µm          2µm

Distance (µm)

44          45

n₁          n₂          n⁺

41          42          43 (substrat)

## Fig. 2

Fig. 5A

ETAPES 1-2

54
53
52
51
50
SUBSTRAT

Fig. 5B

ETAPES 3-4

l
56
55
RIE
54
53
52
51
50
SUBSTRAT

Fig. 5C

ETAPE 5

Attaque chimique
56
54
53
52
51
57
50
SUBSTRAT

Fig. 5D

ETAPE 6

58
54
53
52
51

SEG

SUBSTRAT

50

Fig. 5E

ETAPES 7-8

60
59
54
53
52
51

SEG

58

SUBSTRAT

50

Fig. 5F

ETAPES 9-10

61

60
59
54
53
58
52
51

RIE
62

SEG

SEG

58

SUBSTRAT

50

**Fig. 5G**

ETAPE 11

60
59
58
51
50

Attaque
chimique

SEG

62

52 54

SEG

58

SUBSTRAT

**Fig. 5H**

ETAPES 12-16

p⁺GaAs
p Ga₀.₇Al₀.₃As
p GaAs
n Ga₀.₇Al₀.₃As
n⁺GaAs

Epitaxie
latérale
forcée

60
59
58
54
52
51
50

SEG

63 64 65 66 67

67 66 65 64 63

SEG

SUBSTRAT

**Fig. 5I**

ETAPES 17-18

60
59
63
52
51
50

54

66 65 64

68

67

63

64 65 66

n⁺GaAs
n Ga₀.₇Al₀.₃As
p GaAs
p Ga₀.₇Al₀.₃As
p⁺GaAs

SUBSTRAT

Fig. 6A

ETAPE 5

750 75

Attaque
chimique

74
73
72
71

7.6
77

70 SUBSTRAT

Fig. 6B

ETAPES 12-14

81
Epitaxie
latérale
forcée

80
79
74
78

SEG

82

n⁺ Δn n

n Δn n⁺

SEG

83 84 85

85 84 83

78

SUBSTRAT

Fig. 6C

ETAPES 15-16

87 84 86 84 87 83

83 n⁺ Δn n 85 n Δn n⁺

Fig. 7A

ETAPE 1

93    92    93    92    93

91

SUBSTRAT

Fig. 7B

ETAPE 2

93    94    93    94    93

SEG      SEG

91

SUBSTRAT

Fig. 7C

ETAPE 3

95    94    95    94    95

MONO    MONO

93

91

SUBSTRAT

## Fig. 7D

ETAPE 4

## Fig. 7E

ETAPES 5-6

## Fig. 7F

ETAPE 7

Fig. 8A

Fig. 8B

Fig. 8C

Fig. 8D

Fig. 9A

970
980
973 Gravures mesas en bande
983

Ga As,InP

951

Fig. 9B

Dépot isolant (Si$_3$N$_4$, SiO$_2$)
990
970
Dépot isolant (Si$_3$N$_4$, SiO$_2$)
993
991
AU
992
973

Ga As,InP

951

Fig. 9C

Polyimide
901
910
902
Isolant (SiO$_2$, Si$_3$N$_4$)

991
992

Ga As,InP

Fig. 9D

911
943
912
944
·961
·962
991
992

Ga As,InP

Fig. 10